# EUROPÄISCHE PATENTSCHRIFT

(11) **EP 0 947 001 B1**
(45) Veröffentlichungstag und Bekanntmachung des Hinweises auf die Patenterteilung: **25.05.2005**
(21) Anmeldenummer: 97952721.5
(22) Anmeldetag: 12.12.1997
(51) Int. Cl.: H01L 41/04

(54) **VERFAHREN UND VORRICHTUNG ZUM ANSTEUERN WENIGSTENS EINES KAPAZITIVEN STELLGLIEDES**
METHOD AND DEVICE FOR CONTROLLING AT LEAST ONE CAPACITIVE ACTUATOR
PROCEDE ET DISPOSITIF POUR COMMANDER AU MOINS UN ACTIONNEUR CAPACITIF

(30) Priorität: 18.12.1996 DE 19652801
(43) Veröffentlichungstag der Anmeldung: 06.10.1999
(73) Patentinhaber: SIEMENS AKTIENGESELLSCHAFT, 80333 München (DE)
(72) Erfinder: HOFFMANN, Christian, D-93057 Regensburg (DE); FREUDENBERG, Hellmut, D-93080 Pentling (DE); GERKEN, Hartmut, D-93152 Nittendorf (DE); HECKER, Martin, D-93336 Laimerstadt (DE); PIRKL, Richard, D-93053 Regensburg (DE)
(86) Internationale Anmeldenummer: PCT/DE1997/002906
(87) Internationale Veröffentlichungsnummer: WO 1998/027602

(56) Entgegenhaltungen:
- US-A- 5 130 598
- US-A- 5 543 679
- PATENT ABSTRACTS OF JAPAN vol. 011, no. 127 (E-501), 21.April 1987 & JP 61 271881 A (NIPPON SOKEN INC), 2.Dezember 1986,
- PATENT ABSTRACTS OF JAPAN vol. 018, no. 447 (E-1594), 19.August 1994 & JP 06 140682 A (TOYOTA MOTOR CORP), 20.Mai 1994,
- PATENT ABSTRACTS OF JAPAN vol. 012, no. 064 (M-672), 26.Februar 1988 & JP 62 210241 A (NIPPON DENSO CO LTD;OTHERS: 01), 16.September 1987,

## Beschreibung

Die Erfindung betrifft ein Verfahren und eine Vorrichtung zum Ansteuern eines kapazitiven Stellgliedes, insbesondere eines piezoelektrisch betriebenen Kraftstoffeinspritzventils einer Brennkraftmaschine.

Piezo-Stellglieder bestehen aus einer Vielzahl piezokeramischer Schichten und bilden einen sog. "Stack", der bei Anlegen einer Spannung seine Abmessungen, insbesondere seine Länge s um einen Hub ds verändert, oder bei mechanischem Druck oder Zug eine elektrische Spannung erzeugt.

Die elektrischen Eigenschaften eines derartigen Piezostacks ändern sich mit der Temperatur, der er ausgesetzt ist. Mit steigender Temperatur vergrößert sich seine Kapazität, aber auch der Hub nimmt zu. Bei den für automotive Anwendungen zu berücksichtigenden Temperaturen von etwa -40°C bis +140°C sind dabei Änderungen bis zu einem Faktor 2 zu beobachten.

Aus US 5,387,834 ist eine Ansteuerschaltung für ein piezoelektrisches Element eines Matrix-Druckers bekannt, bei welcher ein Temperatursensor die Temperatur des piezoelektrischen Elements fühlt. Die Ansteuerung des piezoelektrischen Elements erfolgt mit Ladezeiten, welche temperaturabhängig in einer Tabelle gespeichert sind.

Der Hub ändert sich etwa linear mit der angelegten Spannung bei einer bestimmten Stellgliedkapazität bzw. einer bestimmten Temperatur. Ändert sich die Temperatur, so ändert sich auch der Hub bei gleichbleibender Spannung. Hingegen ändert sich der Hub proportional zum Quadrat der aufgebrachten Energie (ds ∼ e²), aber unabhängig von der Temperatur. Einem Stellglied eine bestimmte Energiemenge zuzuführen, ist sehr aufwendig.

Es ist Aufgabe der Erfindung, ein Verfahren zum Ansteuern eines kapazitiven Stellgliedes mit einem vorgegebenen Energiebetrag anzugeben, welches einfach durchzuführen ist. Aufgabe der Erfindung ist es auch, eine Vorrichtung zur Durchführung dieses Verfahrens zu schaffen.

Diese Aufgabe wird erfindungsgemäß durch die Merkmale des Patentanspruchs 1 gelöst.

Ein Ausführungsbeispiel nach der Erfindung ist im folgenden unter Bezugnahme auf die schematische Zeichnung näher erläutert. Es zeigen:
- Figur 1: ein Kennfeld KF für den Zusammenhang zwischen Stellgliedkapazität Cp, Ladespannung Uc, Stellgliedspannung Up und Energie E,
- Figur 2: ein Schaltbild einer Ansteuerschaltung für mehrere Stellglieder, und
- Figur 3: ein Flußdiagramm für die Arbeitsweise der Schaltung nach Figur 2.

Die Erfindung geht von der Überlegung aus, daß es sich bei den Veränderungen der Stellgliedkapazität Cp um temperaturbedingte Veränderungen handelt, die eine gegenüber dem zeitlichen Abstand aufeinanderfolgender Stellgliedbetätigungen bei einer Brennkraftmaschine sehr große Zeitkonstante aufweisen. Es ist deshalb nicht erforderlich, die Regelung der Aufladung im Regelzyklus (Ansteuervorgang) selbst durchzuführen, sondern es genügt vollkommen, eine Regelabweichung in einem Ansteuervorgang festzustellen und diese Regelabweichung im darauffolgenden Ansteuervorgang zu korrigieren.

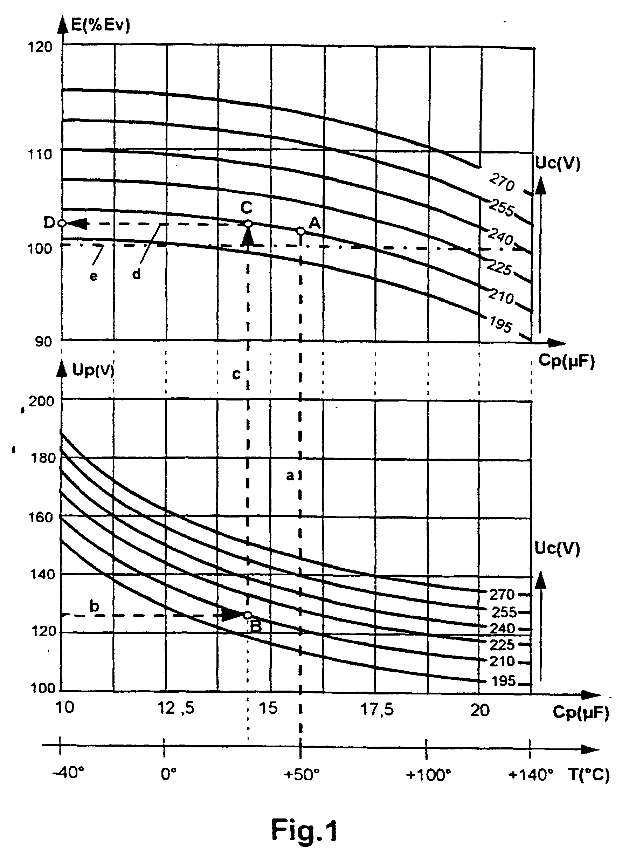

Figur 1 zeigt ein Kennfeld mit zwei experimentell ermittelten oder berechneten Diagrammen, welche den Zusammenhang zwischen Stellgliedkapazität Cp, Ladespannung Uc, Stellgliedspannung Up und Energie E darstellen. Das obere Diagramm zeigt über der temperaturabhängigen Stellgliedkapazität Cp (T und Cp auf der Abszisse aufgetragen) die für verschiedene Ladespannungen Uc erreichbare Energie E im Stellglied, während das untere Diagramm ebenfalls über der temperaturabhängigen Stellgliedkapazität Cp auf der Abszisse die für diese Ladespannungen Uc erzielbare Stellgliedspannung Up darstellt.

Es kann für jedes Stellglied P1 bis Pn ein eigenes Kennfeld KF vorgesehen sein, es kann aber auch für alle Stellglieder oder für jede Stellgliedgruppe ein gemeinsames Kennfeld KF vorgesehen sein.

Durch Betrachtung der Ladespannung Uc und der damit erreichten Stellgliedspannung Up kann auf eine Strommessung, Multiplikation und Integration, wie oben beschrieben, verzichtet werden. Aufgrund des eindeutigen Zusammenhanges zwischen den genannten Größen kann auf annähernd konstante Energie Ev geregelt werden. Ein Wert Ev, relativiert auf 100%Ev, ist in Figur 1 als strichpunktierte Gerade e eingezeichnet.

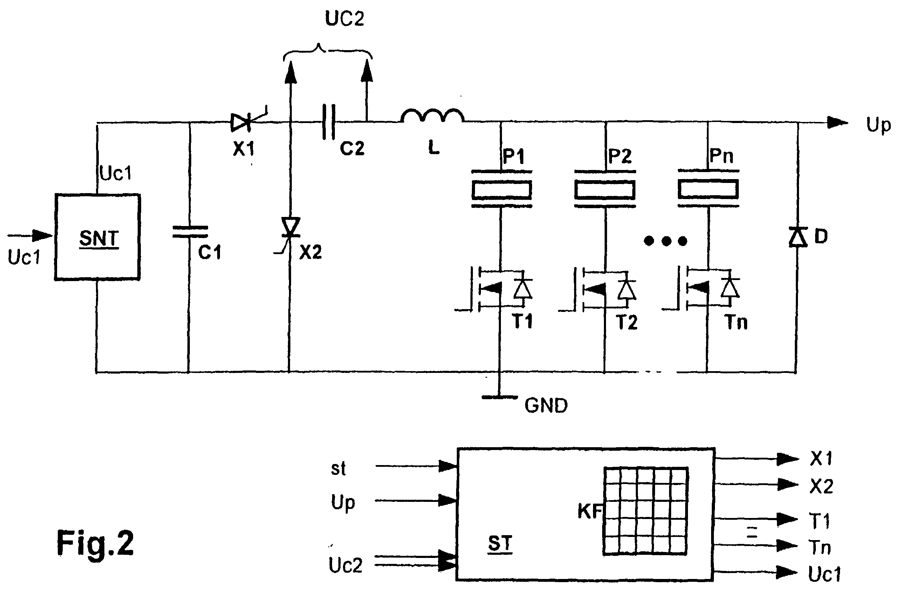

Eine Regelung auf konstante Energie ist insbesondere dann wichtig, wenn die Kapazität Cc des Ladekondensators C von der Stellgliedkapazität Cp erheblich abweicht. Die in Figur 1 dargestellten Diagramme entsprechen einer Schaltung nach Figur 2, in der die Kapazität Cc der Reihenschaltung aus den Kondensatoren C1 + C2 etwa halb so groß ist wie die Kapazität Cp eines Stellgliedes P: Cc = Cp/2.

Das erfindungsgemäße Verfahren wird anhand einer in Figur 2 dargestellten Schaltung näher beschrieben. Die Ansteuerung von weiter nicht dargestellten n Kraftstoffeinspritzventilen einer Brennkraftmaschine über piezoelektrische Stellglieder P1 bis Pn erfolgt mittels einer Steuerschaltung ST, die Teil eines weiter nicht dargestellten mikroprozessor-gesteuerten Motorsteuergerätes ist.

Zwischen dem Pluspol +Uc1 und dem Minuspol GND einer steuerbaren Spannungsquelle SNT, vorzugsweise eines Schaltnetzteils, ist ein Ladekondensator C1 angeschlossen, welcher als Ausgangskondensator des Schaltnetzteils SNT betrachtet werden kann und auf dessen Ausgangsspannung Uc1 aufgeladen ist. Parallel zum Ladekondensator C1 ist eine Reihenschaltung aus einem mit dem Pluspol +Uc1 verbundenen, von ihm weg stromdurchlässigen Ladeschalter X1 und einem mit dem Minuspol GND verbundenen, zu ihm hin stromdurchlässigen Entladeschalter X2 angeordnet.

Wenn von Schaltern X1 und X2 die Rede ist, handelt es sich um elektronische, nur in einer Richtung stromdurchlässige, aus wenigstens einem Halbleiterelement bestehende Schalter, vorzugsweise Thyristorschalter, die von der Steuerschaltung leitend gesteuert werden.

Zwischen dem Verbindungspunkt von Ladeschalter X1 und Entladeschalter X2 und dem Masseanschluß GND liegt eine Reihenschaltung aus einem Umladekondensator C2, einer Umschwingspule L, einem ersten Stellglied P1 und einem ersten, gesteuerten Power-MOSFET-Schalter T1.

Für jedes weitere Stellglied P2 bis Pn ist eine Reihenschaltung aus diesem Stellglied und einem weiteren Power-MOSFET-Schalter T2 bis Tn der Reihenschaltung aus dem ersten Stellglied P1 und dem ersten Power-MOSFET-Schalter T1 parallel geschaltet.

Parallel zu den Reihenschaltungen aus Stellglied und Power-MOSFET-Schalter ist eine vom Masseanschluß GND weg zur Umschwingspule L hin stromdurchlässige Diode D angeordnet. Power-MOSFET-Schalter enthalten üblicherweise Inversdioden, deren Funktion, wie weiter unten näher erläutert, beim Betrieb der erfindungsgemäßen Vorrichtung benutzt wird.

Die Schalter X1, X2 und T1 bis Tn werden von der Steuerschaltung ST entsprechend einem dem erfindungsgemäßen Verfahren zugeordneten Programm, abhängig von Steuersignalen st des Motorsteuergerätes, von der erreichten Stellgliedspannung Up und vom Istwert Uc2 der Spannung am Umladekondensator C2 nach dem Entladen des Stellgliedes, anhand eines in der Steuerschaltung ST gespeicherten Kennfeldes KF nach Figur 1 gesteuert.

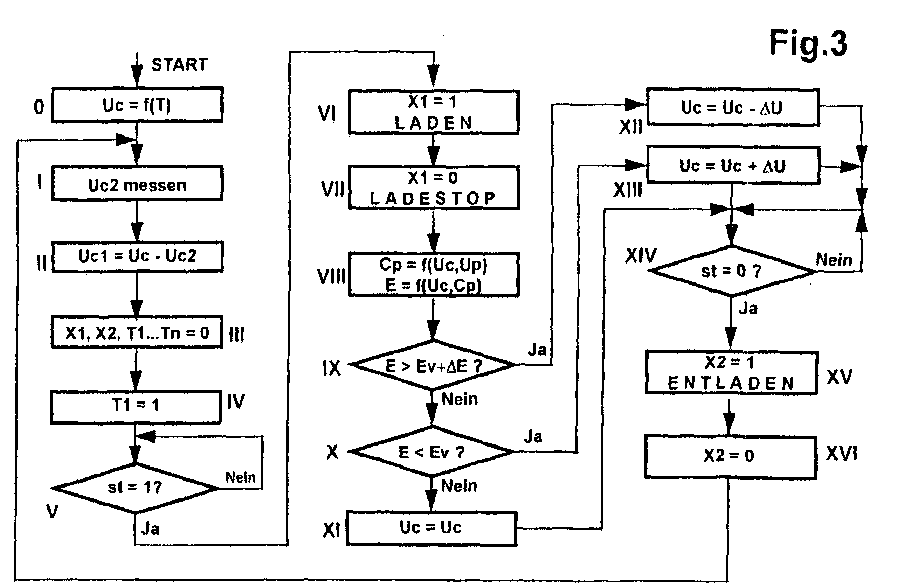

Das erfindungsgemäße Verfahren zum aufeinanderfolgenden Ansteuern mehrerer kapazitiver Stellglieder wird nachstehend anhand des in Figur 3 dargestellten Flußdiagramms unter Zugrundelegung der in Figur 2 gezeigten Schaltung für ein Stellglied P1 näher erläutert. Die einzelnen Kästchen, den jeweiligen Verfahrenszuständen zugeordnet, sind mit römischen Zahlen gekennzeichnet.

Bei einem Zustand III (während des Betriebes), in welchem die Umschwingspule L stromlos ist, alle Schalter X1, X2 und T1 bis Tn nichtleitend (hochohmig) und alle Stellglieder P1 bis Pn entladen sind, soll das Stellglied P1 betätigt werden, um über das zugeordnete Einspritzventil Kraftstoff in den Zylinder 1 einzuspritzen. Die Ladespannung Uc = Uc1 + Uc2 wird beim ersten Ansteuervorgang I bei Inbetriebnahme des Fahrzeuges vorgegeben, Zustand 0.

Beim ersten Ansteuervorgang ist der Umladekondensator C2 entladen. Es findet ein Einschwingvorgang statt, der einen oder mehrere Ladezyklen dauern kann, bis die beim Entladen des Stellgliedes rückgelieferte Spannung Uc2 am Umschwingkondensator C2 nach jedem Entladevorgang beispielsweise einen Wert Uc2 > +100V erreicht. Die maximale Ladespannung Ucmax = Uc1 + Uc2 soll beispielsweise +270V betragen.

Zunächst wählt die Steuerschaltung das entsprechende Stellglied (hier P1) aus, Zustand IV, indem sie den ihm zugeordneten Power-MOSFET-Schalter T1 leitend steuert. T1 kann über einen Kurbelwellenwinkel KW = 720°KW/Z (Z = Zahl der Zylinder) leitend (niederohmig) bleiben, das sind beispielsweise bei Vierzylindermotoren 180°KW und bei Sechszylindermotoren 120°KW.

Beim ersten Ansteuervorgang wählt die Steuerschaltung ST in dem im oberen Diagramm des Kennfeldes KF in Figur 1 eine gespeicherte, experimentell ermittelte oder berechnete Kennlinie der Ladespannung Uc (+210V) aus, welche bei dem der momentanen Stellgliedtemperatur entsprechenden Kapazitätswert des Stellgliedes P oberhalb der gewünschten, dem Stellglied zuzuführenden Energie Ev (im Diagramm durch eine strichpunktierte Linie e gekennzeichnet) liegt, Zustand 0. Da in der Regel die Stellgliedtemperaturen nicht zur Verfügung stehen, kann als Ersatzgröße die Motortemperatur T (im Ausführungsbeispiel +50°C) herangezogen werden, siehe strichlierte Linie a bis zum Punkt A in Figur 1, um einen Näherungswert für die momentane Stellgliedkapazität Cp zu erhalten.

Bei einer einfacheren Ausführung kann einfach ein Anfangswert für die Ladespannung Uc (beispielsweise +210V) unabhängig von der Temperatur vorgegeben sein.

Nach ein oder mehreren Ansteuervorgängen (Einschwingvorgängen) des Stellgliedes P1 sei nach Beendigung eines Entladevorgangs die Spannung des Umladekondensators C2 beispielsweise Uc2 = +120V.

Beim nächsten Einspritzbeginn, der durch den Beginn eines Steuersignals st = 1 (Zustand V) vorgegeben ist, wird von der Steuerschaltung ST der Ladeschalter X1 gezündet (Zustand VI). Dadurch entlädt sich die an der Reihenschaltung aus C1 und C2 liegende Ladespannung Uc = +210V während einer kompletten Sinushalbschwingung über die Umschwingspule L in das Stellglied P1 und dieses öffnet das nicht dargestellte Einspritzventil. Die Spannungsquelle - das Schaltnetzteil SNT - bleibt mit dem Ladekondensator C1 verbunden, so daß auch sie Energie in den Schwingkreis einspeist.

Nach dem Umschwingen verlischt der Ladeschalter X1 von selbst (Zustand VII), das Stellglied P1 ist beispielsweise auf Up = +126V geladen.

Der Wert der Stellgliedspannung Up = +126V wird der Steuerschaltung mitgeteilt, welche im Kennfeld KF (Figur 1) aus Uc = +210V und Up = +126V die dem Stellglied zugeführte Energie bestimmt (Zustand VIII). Dazu wird im unteren Diagramm des Kennfeldes KF im Schnittpunkt B (Uc = +210V; Up = +126V, strichlierte Linie b) der momentane Kapazitätswert Cp ≈ 14,5µF des Stellgliedes P1 bestimmt, und anschließend im oberen Diagramm (Schnittpunkt C von Cp = 14,5µF; Uc = +210V, gestrichelte Linie c) die zugeführte Energie zu E ≈ 102,5%Ev (strichlierte Linie d; Punkt D) ausgelesen.

Je nach "Empfindlichkeit" der Regelung liegt dieser Wert entweder innerhalb eines Toleranzbandes Ev + ΔE der gewünschten Energie (Zustand XI), wobei der nächste Ansteuervorgang mit unveränderter Ladespannung Uc = +210V durchgeführt wird, oder es wird für den nächsten Ansteuervorgang des Stellgliedes P1 ein neuer Wert für die Ladespannung Uc bestimmt, in diesem Ausführungsbeispiel, weil E > Ev + ΔE etwas größer als der gewünschte Wert ist (Zustand IX), beispielsweise von vorgegebenen gespeicherten Stützwerten interpoliert, oder inkrementell um ΔU = 5V vermindert (Zustand XII), auf +205V festgelegt. Dieser Wert ergibt dann im nächsten Ansteuervorgang des Stellgliedes P1, gleiche Stellgliedkapazität vorausgesetzt, etwa einen Wert für die übertragene Energie von E = Ev. Ist die übertragene Energie jedoch kleiner, E < Ev (Zustand X), so wird Uc beim nächsten Ansteuervorgang um ΔU = 5V auf Uc = +215V erhöht (Zustand XIII).

Bei Stellgliedspannungen Up oberhalb eines vorgegebenen Maximalwertes Upmax - beispielsweise +160V - findet vorzugsweise eine reine Spannungsregelung gemäß dem unteren Diagramm von Figur 1 statt, um die Stellgliedspannung auf diesen Wert zu begrenzen.

Zum Entladen des Stellgliedes P1 am Ende eines Steuersignals st (Zustand XIV) wird der Entladeschalter X2 gezündet (Zustand XV). Der Entladestromkreis schließt sich über die Inversdiode des Power-MOSFET-Schalters T1. Die im Stellglied gespeicherte Energie schwingt über die Umschwingspule L in den Kondensator C2 zurück, der auf den bereits erwähnten Wert Uc2 = +120V geladen wird; die im Umladekondensator C2 gespeicherte Energie kann für den folgenden Zyklus genutzt werden.

Sobald das Stellglied auf die Schwellspannung der dem "aktiven" Kanal parallel liegenden Diode D entladen ist, setzt sich der noch fließende Strom über diese Diode fort,wodurch ein Aufladen des Stellgliedes auf eine negative Spannung verhindert wird. Anschließend verlischt der Entladeschalter X2 von selbst (Zustsand XVI).

Für den nächsten Ansteuervorgang des Stellgliedes P1 muß der Ladekondensator C1 auf eine Spannung Uc1 = Uc - Uc2 aufgeladen werden, wozu Uc2 = +120V gemessen wird (Zustand I). Damit kann Uc1 = Uc - Uc2 = +205V - 120V = +85V ermittelt werden (Zustand II). Auf diesen Wert wird das Schaltnetzteil SNT für den nächsten Ansteuervorgang des Stellgliedes P1 eingestellt und damit der Ladekondensator C1 auf Uc1 = +85V geladen. Mit den in diesem Ansteuervorgang ermittelten Werten wirds der nächste Ansteuervorgang, ab Zustand III, durchgeführt. Die Ansteuervorgänge für die anderen Stellglieder P2 bis Pn entsprechen dem beschriebenen Verfahren für das Stellglied P1.

## Patentansprüche

1. Verfahren zum Ansteuern wenigstens eines kapazitiven Stellgliedes (P), insbesondere eines piezoelektrisch betriebenen Kraftstoffeinspritzventils einer Brennkraftmaschine, mit einem vorgebbaren Energiebetrag (Ev),
**dadurch gekennzeichnet,**
- **daß** am Beginn eines Ansteuervorgangs das Stellglied (P1 bis Pn) über eine Umschwingspule (L) aus einer Reihenschaltung eines Ladekondensators (C1) und eines Umladekondensators (C2) mit einer vorgebbaren Ladespannung (Uc = Uc1 + Uc2) geladen wird und am Ende des Ansteuervorgangs in den Umladekondensator (C2) wieder entladen wird,
**daß** aus der Ladespannung (Uc) und der damit am Stellglied erreichten Stellgliedspannung (Up) der temperaturabhängige Kapazitätswert (Cp) des Stellgliedes (P1 bis Pn) ermittelt wird,
**daß** aus diesem Kapazitätswert (Cp) und der Ladespannung (Uc) der dem Stellglied (P1 bis Pn) zugeführte Energiebetrag (E) ermittelt wird, und
**daß** für den nächsten Ansteuervorgang desselben Stellgliedes (P1 bis Pn)
die Ladespannung (Uc) abhängig von der Differenz (Ev - E) von vorgegebenem Energiebetrag (Ev) und zugeführtem Energiebetrag (E) bestimmt wird, und
der Ladekondensator (C1) auf eine der Differenz zwischen dieser bestimmten Ladespannung (Uc) und der momentan am Umladekondensator (C2) anliegenden Spannung (Uc2) entsprechende Spannung (Uc1 = Uc - Uc2) aufgeladen wird.

2. Verfahren nach Anspruch 1, **dadurch gekennzeichnet, daß** Stellgliedkapazitätswerte (Cp), abhängig von der Ladespannung (Uc) und von der damit am Stellglied (P) erreichten Stellgliedspannung (Up),
dem Stellglied (P) zugeführte Energiebetragswerte (E), abhängig von der Ladespannung (Uc) und von diesen ermittelten Stellgliedkapazitätswerten (Cp), und
ein vorgegebener, dem Stellglied zuzuführender Energiebetrag (Ev)
als experimentell ermittelte oder berechnete Werte in einem Kennfeld (KF) nichtflüchtig abgespeichert sind.

3. Verfahren nach Anspruch 2, **dadurch gekennzeichnet, daß** für jedes Stellglied (P1 bis Pn) ein eigenes Kennfeld (KF) vorgesehen ist.

4. Verfahren nach Anspruch 2, **dadurch gekennzeichnet, daß** für alle Stellglieder (P1 bis Pn) oder für jede Stellgliedgruppe ein gemeinsames Kennfeld (KF) vorgesehen ist.

5. Verfahren nach Anspruch 1, **dadurch gekennzeichnet, daß** bei Betriebsbeginn für den ersten Ansteuervorgang jedes Stellgliedes (P1 bis Pn) ein Wert für die Ladespannung (Uc) vorgegeben wird.

6. Verfahren nach Anspruch 5, **dadurch gekennzeichnet, daß** der vorgegebene Wert für die Ladespannung (Uc) von der Motortemperatur (T) abhängig ist.

7. Verfahren nach einem der vorhergehenden Ansprüche, **dadurch gekennzeichnet, daß** ein Maximalwert (Upmax) für die Stellgliedspannung (Up) vorgegeben ist, und daß bei Stellgliedspannungen (Up) oberhalb dieses Maximalwertes (Upmax) eine reine Spannungsregelung (Uc{Up}) stattfindet.

8. Vorrichtung zur Durchführung des Verfahrens nach einem der vorhergehenden Ansprüche, **dadurch gekennzeichnet, daß** zwischen dem Pluspol (+Uc1) und dem Minuspol (GND) einer steuerbaren Spannungsquelle (SNT) ein Ladekondensator (C1) angeordnet ist,
daß parallel zum Ladekondensator (C1) eine Reihenschaltung aus einem mit dem Pluspol (+Uc1) verbundenen, von ihm weg stromdurchlässigen Ladeschalter (X1) und einem mit dem Minuspol (GND) verbundenen, zu ihm hin stromdurchlässigen Entladeschalter (X2) angeordnet ist,
daß zwischen dem Verbindungspunkt von Ladeschalter (X1) und Entladeschalter (X2) und dem Masseanschluß (GND) eine Reihenschaltung aus einem mit dem Ladeschalter (X1) verbundenen Umladekondensator (C2), einer Umschwingspule (L), einem ersten Stellglied (P1) und einem ersten, gesteuerten Power-MOSFET-Schalter(T1) angeordnet ist,
daß für jedes weitere Stellglied eine Reihenschaltung aus diesem Stellglied (P2 bis Pn) und einem weiteren Power-MOSFET-Schalter (T2 bis Tn) der Reihenschaltung des ersten Stellgliedes (P1) und des ersten Power-MOSFET-Schalters (T1) parallel geschaltet ist,
daß parallel zur Reihenschaltung aus erstem Stellglied (P1) und Power-MOSFET-Schalter (T1) eine vom Masseanschluß (GND) zur Umschwingspule (L) hin stromdurchlässige Diode (D) angeordnet ist, und
daß eine Steuerschaltung (ST) vorgesehen ist, mit einem Kennfeld (KF), in dem temperaturabhängige Kapazitätswerte (Cp) des Stellgliedes (P1 bis Pn) in Abhängigkeit von der Ladespannung (Uc) und der damit am Stellglied erreichten Stellgliedspannung (Up) und der in Abhängigkeit aus diesen Kapazitätswerten (Cp) und der Ladespannung (Uc) resultierenden, zugeführten Energiebeträge (E) gespeichert sind,
und welche so ausgebildet ist,
daß sie den Ladeschalter (X1), den Entladeschalter (X2) und die Power-MOSFET-Schalter (T1 bis Tn) steuert, und
daß sie aus den ihr zugeführten Steuersignalen (st) zum Ansteuern der Stellglieder (P1 bis Pn), der am jeweils angesteuerten Stellglied (P1 bis Pn) anliegenden Stellgliedspannung (Up) und der am Umladekondensator (C2) anliegenden Spannung (Uc2) mittels des Kennfeldes (KF) den dem Stellglied übertragenen Energiebetrag (E) ermittelt und abhängig von der Differenz dieses Energiebetrages (E) von dem vorgegebenen Energiebetrag (Ev) die Spannungsquelle (SNT) auf die Ladespannung (Uc1) des Ladekondensators (C1) für den nächsten Ladevorgang einstellt.

9. Vorrichtung nach Anspruch 8, **dadurch gekennzeichnet, daß** die von der Steuerschaltung (ST) steuerbare Spannungsquelle (SNT) ein Schaltnetzteil ist.

10. Vorrichtung nach Anspruch 8, **dadurch gekennzeichnet, daß** Ladeschalter (X1) und Entladeschalter (X2) gesteuerte, elektronische, nur in einer Richtung stromdurchlässige Halbleiterschalter sind.

## Claims

1. Method for controlling at least one capacitive actuator (P), in particular a piezo-electrically operated fuel injection valve in an internal combustion engine, with a predefinable quantity of energy (Ev),
**characterised in that**
- at the start of a control process the actuator (P1 to Pn) is charged via a polarity reversal coil (L) from a series circuit of a charge capacitor (C1) and a charge reversal capacitor (C2) with a predefinable charge voltage (Uc = Uc1 + Uc2) and is discharged again into the charge reversal capacitor (C2) at the end of the control process,
the temperature-dependent capacitance value (Cp) of the actuator (P1 to Pn) is determined from the charge voltage (Uc) and the actuator voltage (Up) achieved as a result at the actuator,
the quantity of energy (E) supplied to the actuator (P1 to Pn) is determined from this capacitance value (Cp) and the charge voltage (Uc), and
for the next control process of the same actuator (P1 to Pn)
the charge voltage (Uc) is defined as a function of the difference (Ev - E) between the predefined quantity of energy (Ev) and the quantity of energy supplied (E), and
the charge capacitor (C1) is charged to a voltage (Uc1 = Uc - Uc2) corresponding to the difference between this defined charge voltage (Uc) and the voltage (Uc2) currently present at the charge reversal capacitor (C2).

2. Method according to Claim 1,
**characterised in that**
actuator capacitance values (Cp) as a function of the charge voltage (Uc) and the actuator voltage (Up) achieved as a result at the actuator (P),
values for energy quantities (E) supplied to the actuator (P), as a function of the charge voltage (Uc) and actuator capacitance values (Cp) determined from these, and
a predefined quantity of energy (Ev) to be supplied to the actuator are stored in a non-volatile manner in performance data (KF) as values determined by experiment or calculation.

3. Method according to Claim 2,
**characterised in that** specific performance data (KF) is provided for each actuator (P1 to Pn).

4. Method according to Claim 2,
**characterised in that** common performance data (KF) is provided for all actuators (P1 to Pn) or for each group of actuators.

5. Method according to Claim 1,
**characterised in that** at the start of operation a value for the charge voltage (Uc) is predefined for the first control process of each actuator (P1 to Pn).

6. Method according to Claim 5,
**characterised in that** the predefined value for the charge voltage (Uc) is a function of engine temperature (T).

7. Method according to one of the preceding Claims,
**characterised in that** a maximum value (Upmax) is predefined for the actuator voltage (Up) and that in the event of actuator voltages (Up) above this maximum value (Upmax) a simple voltage regulation (Uc(Up}) takes place.

8. Device for implementing the method according to one of the preceding Claims,
**characterised in that**
a charge capacitor (C1) is arranged between the plus pole (+Uc1) and the minus pole (GND) of a controllable voltage source (SNT),
a series circuit comprising a charge switch (X1) connected to the plus pole (+Uc1) and allowing the passage of current away from it and a discharge switch (X2) connected to the minus pole (GND) and allowing the passage of current to it, is arranged parallel to the charge capacitor (C1),
a series circuit comprising charge reversal capacitor (C2) connected to the charge switch (X1), a polarity reversal coil (L), a first actuator (P1) and a first, controlled power MOSFET switch (T1) is arranged between the junction point of the charge switch (X1) and the discharge switch (X2) and the earth terminal (GND)
a series circuit comprising said actuator (P2 to Pn) and a further power MOSFET switch (T2 to Tn) is connected parallel to the series circuit comprising the first actuator (P1) and the first power MOSFET switch (T1) for each further actuator (P2 to Pn),
a diode (D) allowing the passage of current from the earth terminal (GND) to the polarity reversal coil (L) is arranged parallel to the series circuit comprising the first actuator (P1) and power MOSFET switch (T1)
a control circuit (ST) is provided, with performance data (KF), in which temperature-dependent capacitance values (Cp) of the actuator (P1 to Pn) are stored as a function of the charge voltage (Uc) and the actuator voltage (Up) achieved as a result at the actuator and the energy quantities (E) supplied as a function of these capacitance values (Cp) and the charge voltage (Uc),
configured such that
it controls the charge switch (X1), the discharge switch (X2) and the power MOSFET switches (T1 to Tn), and
it determines the quantity of energy (E) transferred to the actuator using the performance data (KF) from the control signals (st) fed to it to control the actuators (P1 to Pn), the actuator voltage (Up) present at the respectively controlled actuator (P1 to Pn) and the voltage (Uc2) present at the charge reversal capacitor (C2) and sets the voltage source (SNT) to the charge voltage (Uc1) of the charge capacitor (C1) for the next charging process as a function of the different between this quantity of energy (E) and the predefined quantity of energy (Ev).

9. Device according to Claim 8,
**characterised in that** the voltage source (SNT) that can be controlled by the control circuit (ST) is a switched-mode power supply.

10. Device according to Claim 8,
**characterised in that** the charge switch (X1) and discharge switch (X2) are controlled, electronic semiconductor switches that only allow the passage of current in one direction.

## Revendications

1. Procédé pour exciter au moins un actionneur capacitif (P), en particulier un injecteur de carburant à commande piézoélectrique appartenant à un moteur à combustion interne, avec une quantité d'énergie pouvant être prédéterminée (EV),
**caractérisé**
**en ce qu'**au début d'une opération d'excitation, l'actionneur (P1 à Pn) est chargé avec une tension de charge prédéterminée (Uc = Uc1 + Uc2) à travers une bobine d'oscillation (L), à partir d'un circuit série composé d'un condensateur de charge (C1) et d'un condensateur à inversion de charge (C2), et de nouveau déchargé dans le condensateur à inversion de charge (C2) à la fin de l'opération d'excitation,
**en ce qu'**à partir de la tension de charge (Uc) et de la tension d'actionneur (Up) atteinte sur l'actionneur, on obtient la valeur de capacité (Cp), variable avec la température, de l'actionneur (P1 à Pn),
**en ce qu'**à partir de cette valeur de capacité (Cp) et de la tension de charge (Uc), on obtient la quantité d'énergie (E) apportée à l'actionneur (P1 à Pn), et
**en ce que**, pour l'opération d'excitation suivante du même actionneur (P1 à Pn), la tension de charge (Uc) est déterminée en fonction de la différence (Ev-E) entre la quantité d'énergie prédéterminée (Ev) et la quantité d'énergie apportée (E), et
le condensateur de charge (C1) est chargé à une tension (Uc1 = Uc - Uc2) qui correspond à la différence entre cette tension de charge déterminée (Uc) et la tension (Uc2) qui est appliquée au moment considéré au condensateur à inversion de charge (C2).

2. Procédé selon la revendication 1, **caractérisé en ce que**
des valeurs de capacité (Cp) des actionneurs, qui dépendent de la tension de charge (Uc) et de la tension d'actionneur (Up) qui est atteinte de cette façon sur l'actionneur (P),
des valeurs de quantité d'énergie (E) apportées à l'actionneur (P), qui dépendent de la tension de charge (Uc) et des valeurs de capacité des actionneurs (Cp) obtenues à partir de ces valeurs, et
une quantité d'énergie prédéterminée (Ev), qui doit être apportée à l'actionneur sont enregistrées de façon non volatile dans un diagramme (KF) sous la forme de valeurs obtenues expérimentalement ou calculées.

3. Procédé selon la revendication 2, **caractérisé en ce que**, pour chaque actionneur (P1 à Pn), est prévu un diagramme (KF) qui lui est propre.

4. Procédé selon la revendication 2, **caractérisé en ce qu'**il est prévu un diagramme commun (KF) pour tous les actionneurs (P1 à Pn) ou pour chaque groupe d'actionneurs.

5. Procédé selon la revendication 1, **caractérisé en ce qu'**au début du fonctionnement, une valeur pour la tension de charge (Uc) est prédéterminée pour la première opération d'excitation de chaque actionneur (P1à Pn).

6. Procédé selon la revendication 5, **caractérisé en ce que** la valeur prédéterminée pour la tension de charge (Uc) est fonction de la température (T) du moteur.

7. Procédé selon une des revendications, **caractérisé en ce qu'**une valeur maximale (Upmax) pour la tension de l'actionneur (Up) est prédéterminée et que, dans le cas de tensions d'actionneur (Up) supérieures à cette valeur maximale (Upmax), il se produit une régulation de tension pure (Uc{Up}).

8. Dispositif pour la mise en oeuvre du procédé selon une des revendications précédentes, **caractérisé en ce qu'**entre le pôle Plus (+ Uc1) et le pôle Moins (GND) d'une source de tension pouvant être commandée (SNT), est disposé un condensateur de charge (C1), **en ce que**,
en parallèle avec le condensateur de charge (C1), est connecté un circuit série composé d'un interrupteur de charge (X1), connecté au pôle Plus (+Uc1), et qui laisse passer le courant en provenance de ce pôle, et d'un interrupteur de décharge (X2) connecté au pôle Moins (GND) et qui laisse passer le courant en direction de ce pôle,
**en ce qu'**entre le point de jonction entre l'interrupteur de charge (X1) et l'interrupteur de décharge (X2) et la connexion de masse (GND), est disposé un circuit série composé d'un condensateur à inversion de charge (C2) relié à l'interrupteur de charge (X1), d'une bobine d'oscillation (L), d'un premier actionneur (P1) et d'un premier interrupteur Power-MOSFET commandé (T1),
**en ce que**, pour chaque autre actionneur, un circuit série composé de cet actionneur (P2 à Pn) et d'un autre interrupteur Power-MOSFET (T2 à Tn) est connecté en parallèle avec le circuit série composé du premier actionneur (P1) et du premier interrupteur Power-MOSFET (T1),
**en ce qu'**une diode (D) qui laisse passer le courant de la connexion de masse (GND) à la bobine d'oscillation (L) est connectée en parallèle avec le circuit série composé du premier actionneur (P1) et de l'interrupteur Power-MOSFET (T1),
et **en ce qu'**il est prévu un circuit de commande (ST) comprenant un diagramme (KF) dans lequel sont mémorisées des valeurs de capacité (Cp), variables avec la température, de l'actionneur (P1 à Pn) en fonction de la tension de charge (Uc) et de la tension d'actionneur (Up) qui est atteinte sur l'actionneur, et des quantités d'énergie (E) apportées, qui résultent en fonction de ces valeurs de capacité (Cp) et de la tension de charge (Uc), et qui est constitué de telle manière qu'il commande l'interrupteur de charge (X1), l'interrupteur de décharge (X2) et les interrupteurs Power-MOSFET (T2 à Tn), et
**en ce que**, sur la base des signaux de commande (ST) qui lui sont transmis pour l'excitation des actionneurs (P1 à Pn), de la tension (Up) d'actionneur qui est appliquée à l'actionneur (P1 à Pn) respectivement excité, et de la tension (Uc2) appliquée au condensateur à inversion de charge (C2), il obtient, au moyen du diagramme (KF), la quantité d'énergie (E) transmise à l'actionneur et, en fonction de la différence entre cette quantité d'énergie (E) et la quantité d'énergie prédéterminée (Ev), il règle la source de tension (SNT) sur la tension de charge (Uc1) du condensateur de charge (C1) pour l'opération de charge suivante.

9. Dispositif selon la revendication 8, **caractérisé en ce que** la source de tension (SNT) qui peut être commandée par le circuit de commande (ST) est une partie de circuit de réseau.

10. Dispositif selon la revendication 8, **caractérisé en ce que** l'interrupteur de charge (X1) et l'interrupteur de décharge (X2) sont des interrupteurs à semiconducteur électroniques commandés, qui ne laissent passer le courant que dans un sens.
